# EUROPEAN PATENT APPLICATION

(11) **EP 4 546 959 A1**
(43) Date of publication of application: **30.04.2025**
(21) Application number: 23205524.4
(22) Date of filing: 24.10.2023
(51) Int. Cl.: H05K 7/14

(54) **COVER AND HOUSING WITH COVER**

(71) Applicant: MAHLE International GmbH, 70376 Stuttgart (DE)
(72) Inventor: GARCIA, Juan Isidro, 33820 Grado (ES)
(74) Representative: BRP Renaud & Partner mbB Rechtsanwälte Patentanwälte Steuerberater

(57) **Abstract**

The present invention relates to a cover (5) for a housing (1), in particular an electrical housing for accommodating electrical and/or electronic components (8), the cover (5) having a plate-shaped, rectangular cover body (14) which has a circumferential cover edge (15), and having a circumferential flange (6) formed on the cover edge (15) for fastening the cover (1) to the housing (1).

The cover (5) can be stiffened and stabilized if the cover body (14) has at least one row of bumps (19) with an odd number of bumps (20, 21) projecting in the cover height direction (Z) from the cover plane (E), and if the bumps define first bumps (20) and second bumps (21) which are different from each other and alternate in the cover longitudinal direction (X).

## Description

The present invention relates to a cover for a housing, in particular for an electrical housing for accommodating electrical and/or electronic components.

A housing usually has a housing body which has a housing opening and in which a housing interior is formed which is accessible through the housing opening. The housing may be provided with a cover for closing the housing opening, which is suitably fixed to the housing body for this purpose. Such a cover usually has a plate-shaped cover body which can be fastened to the housing body via a circumferential flange. If the housing is subjected to differential pressure during use, the cover may deform, which may affect the tightness of the connection between the cover and the housing. In addition, the housing may be subjected to alternating pressure loads which may excite the housing, and in particular the cover, to vibrate. If this vibration excitation occurs in the range of the natural frequency or eigenfrequency of the cover, it can lead to resonance vibrations, which can result in particular in undesirable noise development and wear of the housing.

To remedy this situation, it is possible, for example, to increase the wall thickness of the cover and/or to use a stronger material for manufacturing the cover and/or to provide a larger number of connection points between the cover and the housing body and/or to equip the cover with stiffening ribs. However, the above measures are comparatively expensive.

The present invention is concerned with the problem of providing an improved embodiment for a cover or for a housing equipped therewith, which provides a comparatively stable cover which can, however, be manufactured comparatively inexpensively.

US 2021/0 237 799 A1 describes a high-strength metal plate for the manufacturing of vehicles in which a plurality of identical oval bumps is stamped on one side of the plate so that all the bumps form a recess on one side of the plate and protrude on the other side. The oval bumps have shorter and longer bump axes and are arranged on the metal plate in such a way that the longer bump axes of adjacent bumps are perpendicular to one another.

The problem underlying the invention is solved by the subject-matter of the independent claim. Advantageous embodiments are the subject of the dependent claims.

In this regard, the invention is based on the general idea of forming on the cover an odd number of bumps or dents or bulges or bumps defining first and second bumps which are different from each other and which are arranged alternately adjacent to each other on the cover. It has been shown that covers provided with two different alternating bumps have a higher stiffness, which can reduce deformation when a differential pressure is applied thereto. In particular, sufficient dimensional stability can be achieved for the cover without having to increase the wall thickness or thickness of the cover, or having to use an increased number of fasteners, or having to use higher-quality, expensive materials. By stiffening the cover with the aid of such bumps, the natural frequency of the cover is shifted to significantly higher frequencies, which are not achieved in a large number of applications. This allows undesirable noise generation and wear to be reduced. The bumps, which can also be called bulges or dents or bumps, can be provided by embossments during forming or production of the cover body.

More specifically, the invention proposes to provide the cover with a plate-shaped rectangular cover body having a circumferential cover edge or cover rim. In addition, a circumferential flange is formed on the cover for securing the cover to the housing, which flange may include, for example, a plurality of screw holes distributed along the cover edge. The cover body is configured to define a longitudinal cover direction, a cross cover direction, and a height cover direction that are perpendicular to each other. Further, the plate-shaped cover body defines a cover plane extending in particular perpendicular to the cover height direction. Within the flange, the cover body has a cover thickness or wall thickness in the cover height direction, a cover length in the cover length direction and a cover width in the cover cross direction. The cover thickness is smaller than the cover length and smaller than the cover width. In particular, the cover thickness can be at least five times, preferably at least ten times, advantageously at least twenty times smaller than the cover length and the cover width. In the case of a square cover body, the cover length and the cover width are equal. In a rectangular cover body, the cover length is greater than or smaller than the cover width. The cover has a cover bottom side facing the interior of the housing when the cover is attached to the housing or, respectively, to the housing body, and a cover upper side facing away from the cover bottom side in the cover height direction. In such a configuration of the cover, the cover body has at least one row of bumps comprising an odd number of bumps projecting from the cover plane in the cover height direction. These bumps define first bumps and second bumps that are different from each other and alternate in the cover longitudinal direction.

In the present context, a "configuration" is synonymous with a "design", so that the phrase "configured so that" is synonymous with the phrase "designed so that."

Accordingly, the cover body has at least three bumps or at least five or at least seven bumps in the respective row of bumps, and so on. If there are exactly three bumps, then one first bump and two second bumps may be provided, or two first bumps and one second bump. Accordingly, when there are five or seven or more bumps, there are then multiple first bumps and multiple second bumps. Insofar as a plurality of first bumps are provided, they are of the same or identical design or construction. If several second bumps are provided, they are of the same or identical design.

According to an advantageous embodiment, the cover body may include planar portions adjacent to the cover edge and the bumps extending in the cover plane. The first bumps preferably may project upwardly from the cover bottom side directed away from the cover plane, while the second bumps may project downwardly from the cover upper side directed away from the cover plane. Similarly, a reverse design is possible in which the second bumps protrude upwardly from the cover bottom side directed away from the cover plane while the first bumps protrude downwardly from the cover upper side directed away from the cover plane. It has been shown that the different bumps, which differ from each other at least in that they project in opposite directions from the cover plane, result in significant stiffening of the cover.

By the aforementioned preferred embodiment, the first bumps are concave at the cover bottom side while they are convex at the cover upper side. In contrast, in this configuration, the second bumps are convex at the cover bottom side and concave at the cover upper side.

According to an advantageous embodiment, the bumps in the cover plane can be elliptical or oval and each have a longer bump axis in the cover plane and a shorter bump axis in the cover plane, wherein the shorter bump axis runs perpendicularly to the longer bump axis. All the bumps of the respective row of bumps are arranged in the cover body in such a way that the longer bump axes of all the bumps run parallel to one another. This measure also contributes to the stiffening of the cover.

It is expedient to arrange all the bumps of the respective row of bumps in the cover body in such a way that the longer bump axes run parallel to the cover cross direction. Particularly in the case of a rectangular cover, where the cover length is greater than the cover width, this alignment of the longer bump axes results in significant stiffening.

In another embodiment, it may be provided that the longer bump axes of the first bumps are the same size as the longer bump axes of the second bumps. Additionally, it may be provided that the shorter bump axes of the first bumps are larger than the shorter bump axes of the second bumps. These features result in a significant stiffening of the cover, particularly in the case of a rectangular cover where the cover length is greater than the cover width.

In an advantageous embodiment, the number of first bumps is greater than the number of second bumps, so that the first bumps are adjacent and/or contiguous to the cover edge in the cover longitudinal direction. It has been shown that this configuration is particularly advantageous with respect to the stiffening of the cover.

Another embodiment suggests that the shorter bump axes of the first bumps are at least twice as large as the shorter bump axes of the second bumps. As a result, the second bumps are comparatively small in the cover longitudinal direction, which significantly increases their stiffening effect.

The significantly different shorter bump axes of the alternating bumps, especially when combined with the bumps protruding from the cover body on opposite sides, results in a significant increase in the natural frequency of the cover.

In another embodiment, it may be provided that in the cover height direction, a maximum distance of the first bumps from the cover plane is greater than a maximum distance of the second bumps from the cover plane. Thus, the first bumps protrude further from the cover plane than the second bumps. The maximum distance of the respective bump is present in a central region, in particular in the zenith, of the respective bump. The different maximum distances can significantly improve the stiffness of the cover, particularly in combination with the different sizes of the shorter bump axes and/or with the different bumps extending in opposite directions from the cover plane.

In another embodiment, the bumps, at least in a central region, can have a circular arc-shaped contour cross to the cover cross direction, i.e. in a sectional plane running cross or transversal to the cover cross direction. It can now be provided that a radius of the contour of the first bumps is larger than a radius of the contour of the second bumps. The different radii can improve the stiffening of the cover, in particular in conjunction with the bumps projecting in the opposite directions from the cover plane. The central area of the respective bump includes the zenith of the respective bump.

For example, the radius of the contour of the first bumps can be at least twice, alternatively at least three times, alternatively at least four times, alternatively at least five times, as large as the radius of the contour of the second bumps. This makes the radius of the contour of the second bumps comparatively small compared to the radius of the contour of the first bumps, so that the stiffening is significantly improved in this area.

According to another embodiment, within the respective row of bumps, the first bumps and the second bumps may be directly adjacent to each other or merge into each other in the cover longitudinal direction. Thus, there are no planar sections between bumps that are adjacent in the cover longitudinal direction, which further improves the stability of the cover.

Another advantageous embodiment suggests that the bumps each extend in the cover cross direction over substantially the entire cover width. This applies in the case where the cover body has only one row of bumps. If, on the other hand, the cover body has exactly two rows of bumps adjacent in the cover cross direction, the bumps of the respective row of bumps in the cover cross direction preferably each extend over substantially half the cover width. Generally speaking, a configuration is thus proposed in which the cover body has n rows of bumps adjacent in the cover cross direction, the bumps of the respective row of bumps each extending in the cover cross direction substantially over 1/n of the cover width.

Additionally or alternatively, the bumps of the respective row of bumps may extend together in the cover longitudinal direction over substantially the entire cover length. The phrase "substantially" in this context is synonymous with the phrase "at least 90%, in particular at least 95%". These embodiments also reduce the area fraction of the planar sections, which improves the strength and stability of the cover.

In principle, it is conceivable that the cover body with the flange is a single injection-molded part made of plastic or a single die-cast part made of metal on which the bumps are already formed. The cover body is therefore configured with the flange and with the bumps to suit the mold. It is also conceivable, that the bumps are formed by embossments in the already molded cover.

Alternatively, the cover body with the flange can be a sheet metal form part made from a single piece of sheet metal by forming. This also forms the bumps in the cover body by forming. Forming metallic sheet metal pieces results in areas of increased rigidity in the sheet metal molding and thus in the cover, which additionally increases the stability of the cover.

In another embodiment, the cover edge may have a circumferential collar projecting from the cover plane in the cover height direction, on which the flange is formed. The flange may now extend in a flange plane which extends parallel to the cover plane and which is spaced from the cover plane in the cover height direction. The collar angled away from the cover body and the flange angled away from the collar results in significant stiffening of the cover. Furthermore, this collar can be easily produced during deep drawing or forming of a piece of sheet metal, thereby providing additional stiffening. The flange can be shaped in terms of its outer contour during forming of the sheet metal piece by a stamping process.

A housing according to the invention, which is preferably an electrical housing for accommodating electrical and/or electronic components, has a housing body which provides a housing interior and has a housing opening. The housing is also equipped with a cover of the type described above, which is attached to the housing body by means of the flange and thus closes the housing opening. The pressure-stable cover thus also improves the pressure stability of the housing.

It is clear that a suitable seal can be provided between the cover and the housing, which in particular can already be formed on the cover. For example, a gasket made of a suitable sealing material molded directly onto the flange is conceivable.

Further important features and advantages of the invention are apparent from the depending claims, from the drawings, and from the accompanying figure description based on the drawings.

It is understood that the above-mentioned features and those still to be explained below can be used not only in the respective combination indicated, but also in other combinations or on their own, without leaving the scope of the invention defined by the claims. Components of a superordinate unit, such as a device, an apparatus or an arrangement, mentioned above and still to be mentioned below, which are designated separately, may form separate parts or components of this unit or be integral areas or sections of this unit, even if this is shown otherwise in the drawings.

Preferred embodiments of the invention are shown in the drawings and will be explained in more detail in the following description, wherein identical reference signs refer to identical or similar or functionally identical components.

The drawings show, each schematically,
- Figure 1: a highly simplified longitudinal section of a housing with a cover,
- Figure 2: an isometric view of the cover,
- Figure 3: a longitudinal section of the cover according to section lines III in Figure 2,
- Figure 4: a cross-section of the cover corresponding to section lines IV in Fig-ure 2,
- Figure 5: a cross-section of the cover corresponding to section lines V in Fig-ure 2,
- Figure 6: an isometric view of the cover, but in a different embodiment.

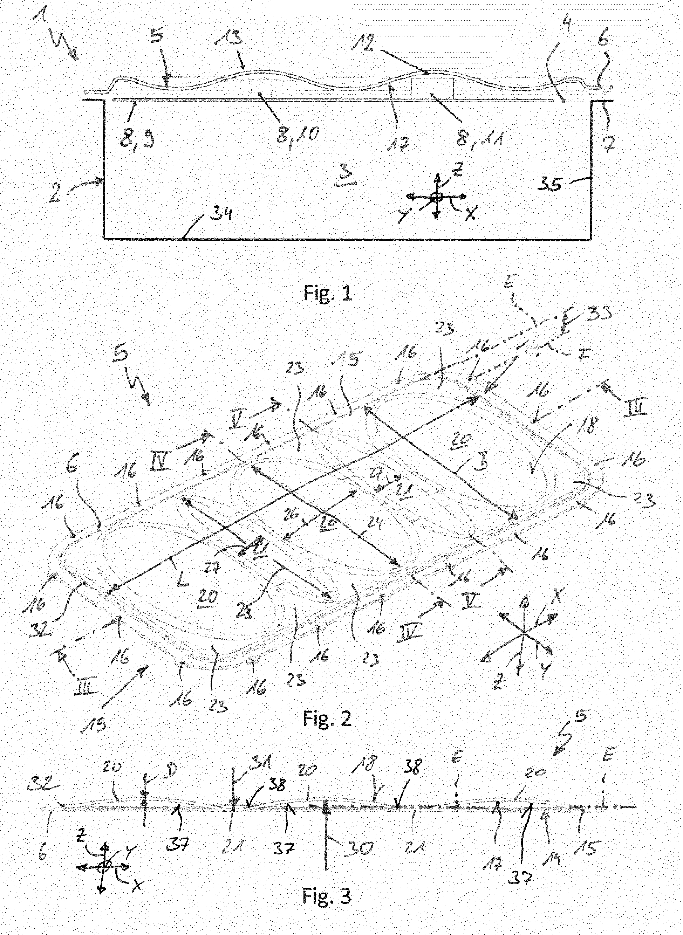

According to Figure 1, a housing 1 comprises a housing body 2 which provides a housing interior 3 and which has a housing opening 4. The housing 1 is also provided with a cover 5, which is attached to a matching mating flange 7 of the housing body 2 via a flange 6 of the cover 5. The cover 5 thereby closes the housing opening 4. The attachment of the cover 5 via the flange 6 to the housing body 2 can be carried out, for example, with the aid of screw connections not shown here. The housing 1 can be configured in particular as an electrical housing and serve to accommodate electrical and/or electronic components, 8. In the example of Figure 1, one of the components 8 can be a printed circuit board 9. Another component 8 can be configured purely exemplarily as a capacitor 10. Another component 8 can be designed purely exemplarily as a coil or inductor 11. In particular, it can be provided that the inductor 11 is supported on the cover 5 via a thermal conductive material 12 or a TIM 12, wherein TIM stands for thermal interface material. In contrast, the capacitor 10 can be arranged in an area 13 at a distance from the cover 5.

In a conventional manner, the housing body 2 may have a housing base 34 and a housing wall 35 projecting therefrom. The housing base 34 limits the housing interior 3 downward. The housing wall 35 limits the housing interior 3 laterally and has the mating flange 7. The cover 5 attached to the housing body 2 limits the housing interior 3 upwardly.

In the following, the cover 5 is explained in more detail with reference to Figures 2 to 6, whereby these explanations also apply in a corresponding manner to the cover 5 shown in Figure 1.

According to Figures 2 to 6, the cover 5 has a plate-shaped rectangular cover body 14 that has a completely circumferential cover edge 15. Furthermore, the cover 5 has the flange 6, which is formed on the cover edge 15 and runs completely around it. With the aid of the flange 6, the cover 5 can be fastened to the housing 1 or, respectively, to the housing body 2. For this purpose, the flange 6 can have several screw openings 16, which are arranged distributed along the cover edge 15.

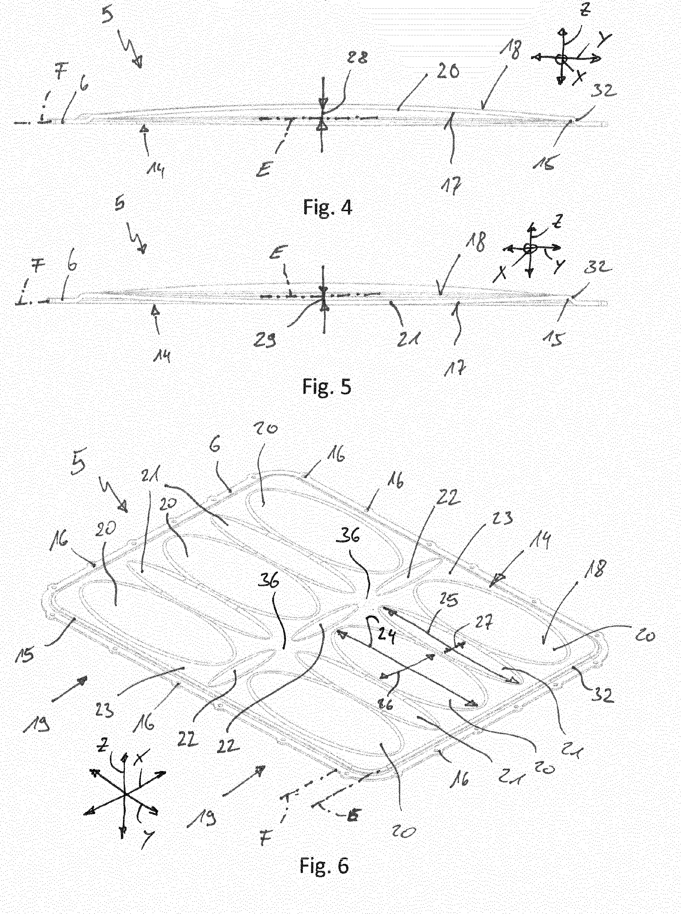

The cover body 14 defines a cover longitudinal direction X, a cover cross direction Y, and a cover height direction Z that are perpendicular to each other. In addition, the cover body 14 defines a cover plane E that is perpendicular to the cover height direction Z. Within the flange 6, the cover body 14 has a cover thickness D measured in the cover height direction Z and visible in the sectional views of Figures 3 to 5, which corresponds to a wall thickness of the cover body 14. Furthermore, the cover body 14 has a cover length L measured in the longitudinal cover direction X and a cover width B measured in the cross cover direction Y within the flange 6. The cover 5 has a cover bottom side 17, which can be seen in the sectional views of Figures 1 and 3 to 5 and which faces the housing 1 or the housing body 2 or the housing interior 3 when the cover 5 is attached to the housing 1. The cover 5 further has a cover upper side 18 which faces away from the cover bottom side 17 in the cover height direction Z. In the example of Figure 2, the cover length L is greater than the cover width B. In the example of Figure 6, however, the cover width B is greater than the cover length L.

The cover 5 is also provided with at least one row of bumps 19, which has an odd number of bumps 20, 21. These bumps 20, 21 thereby protrude or project, respectively, from the cover plane E in the cover height direction Z. The bumps 20, 21 thereby define first bumps 20 and second bumps 21 which are different from each other and which alternate in the cover longitudinal direction X. Thereby, all first bumps 20 are designed to be the same or identical among each other. All second bumps 21 are also identical or identical to one another. Consequently, all first bumps 20 are different from all second bumps 21.

In the example of Figure 2, the cover 5 has exactly one row of bumps 19 in which, purely by way of example, exactly five bumps 20, 21 are arranged, namely exactly three first bumps 20 and exactly two second bumps 21, wherein each second bump 21 is arranged between two first bumps 20. In the example of Fig-ure 6, the cover 5 has exactly two such rows of bumps 19, each of which has exactly five such bumps 20, 21, in which case, too, exactly three first bumps 20 and exactly two second bumps 21 are provided in each case, each of which is arranged between two first bumps 20. The two rows of bumps 19 are thereby arranged next to one another in the cover cross direction Y. In addition, it is shown in Figure 6 that further or third bumps 22 can be arranged in the cover body 14 between two adjacent rows of bumps 19, which will be discussed in more detail below.

The cover body 14 may have planar sections 23 adjacent to the cover edge 15 and to the bumps 20, 21. The planar sections 23 thereby extend in the cover plane E. As can be seen in particular from the sectional views of Figures 1 and 3 to 5, the first bumps 20 may project upwardly from the cover plane E so that they project away from the cover bottom side 17. In contrast, the second bumps 21 project downwardly from the cover plane E so that they project away from the cover upper side 18. In other words, the first bumps 20 and the second bumps 21 project in opposite directions from the cover plane E in the cover height direction Z. Thus, at the cover upper side 18, the first bumps 20 are convexly curved, while the second bumps 21 are concavely curved. On the cover bottom side 17, on the other hand, the first bumps 20 are concavely curved, while the second bumps 21 are convexly curved.

According to Figures 2 and 6, the bumps 20, 21 can be elliptical or oval in sectional planes running cross or transversely to the cover height direction Z, in particular in the cover plane E. The first bumps 20 have a longer bump axis 24 and a shorter bump axis 26 running perpendicular thereto. In the respective sectional planes or in the cover plane E, the first bumps 20 each have a longer bump axis 24 and a shorter bump axis 26 extending perpendicularly thereto, while the second bumps 21 each have a longer bump axis 25 and a shorter bump axis 27 extending perpendicularly thereto. In this regard, all of the bumps 20, 21 in the cover body 14 are oriented such that the longer bump axes 24, 25 extend parallel to each other for all of the bumps 20, 21. Furthermore, the longer bump axes 24, 25 run parallel to the cross cover direction Y for all of the bumps 20, 21. Here, the term "bump axis" means the diameter along the respective axis of the respective bump 20, 21. Thus, the longer bump axis 24, 25 means the diameter along the major axis, while the shorter bump axis 26, 27 means the diameter along the minor axis.

In the embodiments shown herein, the longer bump axes 24 of the first bumps 20 are the same size as the longer bump axes 25 of the second bumps 21. In contrast, however, the shorter bump axes 26 of the first bumps 20 are larger than the shorter bump axes 27 of the second bumps 21. As can be further seen from the examples shown herein, the bump 20, 21 may preferably be configured such that the shorter bump axes 26 of the first bump 20 are at least twice as large as the shorter bump axes 27 of the second bump 21. In the shown examples the first bumps 20 and the second bumps 21 of the respective bump row 19 are arranged in such a way, that their shorter bump axes 26, 27 extend along a common bump axis running in the cover longitudinal direction X.

Preferred configurations are those shown in Figures 2 and 6, in which the respective bump row 19 has more first bumps 20 than second bumps 21. Since the first bumps 20 and the second bumps 21 alternate in the respective bump row 19, the number of first bumps 20 is always one greater than the number of second bumps 21. With five bumps 20, 21 per bump row 19, there are then two second bumps 21 and two plus one, that is, three first bumps 20.

The cross-section shown in Figure 4 is laid through one of the first bumps 20. The respective first bump 20 has a maximum distance 28 in the cover height direction Z relative to the cover plane E. The cross section shown in Figure 5 runs through one of the second bumps 21. The second bump 21 has a maximum distance 29 relative to the cover plane E. The maximum distance 28 of the first bump 20 is now recognizably larger, in particular at least twice larger, than the maximum distance 29 of the second bump 21.

According to Figure 3, the first bumps 20 have a circular arc-shaped contour 37 with a radius 30, which is indicated by an arrow in Figure 3, at least in a central region cross to the cover cross direction Y, which is perpendicular to the drawing plane in the longitudinal section of Figure 3. The second bumps 21 have, crossly to the cover cross direction Y, i.e. in longitudinal section, at least in a central region, a circular arc-shaped contour 38 which has a radius 31 which is indicated by an arrow in Figure 3. The radius 30 of the contour 37 of the first bump 20 is larger than the radius 31 of the contour 38 of the second bump 21. The radius 30 of the first bump 20 can be at least twice as large as the radius 31 of the second bump 21. In the example shown, the radius 30 of the first bump 20 is about five times larger than the radius 31 of the second bump 21.

According to Figures 2 and 3, the bumps 20, 21 on the cover body 14 are formed in such a way that in the respective row of bumps 19 the first bumps 20 and the second bumps 21 are directly adjacent to one another in the cover longitudinal direction X or merge directly into one another. In the example of Figure 2, in which the cover body 14 has only a single row of bumps 19, the bumps 20, 21 each extend in the cover cross direction Y over essentially the entire cover width B.

In contrast to this, in the embodiment of the cover 5 shown in Figure 6, the cover body 14 has exactly two rows of bumps 19 which are arranged next to one another in the cover cross direction Y. In this case, it can be expediently provided that the bumps 20, 21 of the respective row of bumps 19 each extend in the cover cross direction Y essentially over half the cover width B. In other embodiments, the cover body 14 may also have three or more rows of bumps 19. Accordingly, the cover body 14 may generally have n rows of bumps 19 arranged side by side in the cover cross direction Y. In this case, it may be expediently provided that the bumps 20, 21 of the respective bump row 19 each extend in the cross cover direction Y substantially over 1/n of the cover width B, i.e. over 1/3 in the case of three bump rows 19, over 1/4 in the case of four bump rows 19, and so on. In the case of a cover 5 whose cover body 14 has a plurality of bump rows 19, the cover body 14 may also be configured in a square shape or configured such that the cover width B is greater than the cover length L, which is the case in the example of Figure 6.

Within the respective row of bumps 19, the associated bumps 20, 21 extend together in the cover longitudinal direction X over substantially the entire cover length L.

Expediently, the cover body 14 including the flange 6 is a sheet metal formed part made from a single piece of sheet metal by forming. During this forming process, the bumps 20, 21 are also formed.

According to Figures 2 to 6, the cover edge 15 may have a fully circumferential collar 32 projecting from the cover plane E in the cover height direction Z, on which the flange 6 is formed. The flange 6 then extends in a flange plane F which extends parallel to the cover plane E and which is spaced from the cover plane E in the cover height direction Z. A corresponding distance 33 is shown as an example in Figure 2.

In the example of Figure 6, two rows of bumps 19 are formed on the cover body 14, which are arranged next to each other in the cover cross direction Y. The bumps 20, 21 of these two bump rows 19 are positioned in such a way that the first bumps 20 of one bump row 19 are aligned with the first bumps 20 of the other bump row 19 in the cover cross direction Y. As a result, the second bumps 21 of one row of bumps19 are also automatically aligned with the second bumps 21 of the other row of bumps 19 in the cover cross direction Y. According to Fig-ure 6, further or third bumps 22 may be formed in the cover body 14 in the cover cross direction Y between two adjacent rows of bumps 19. These third bumps 22 differ from the first bumps 20 and from the second bumps 21, being obviously of smaller dimensions. They may project upwardly like the first bumps 20, or they may project downwardly like the second bumps 21. The third bumps 22 may also be elliptical or oval in shape and have a longer bump axis and a shorter bump axis perpendicular thereto. Here, the third bumps 22 are oriented such that their longer bump axes are parallel to the cover longitudinal direction X, as rotated 90° with respect to the longer bump axes 24 of the first bumps 20 and with respect to the longer bump axes 25 of the second bumps 21. Further, the third bumps 22 may be dimensioned and arranged on the cover body 14 such that each two third bumps 22 adjacent in the cover longitudinal direction X and each two second bumps 21 adjacent in the cover cross direction Y of adjacent rows of bumps 19 are arranged in a cross-shaped or star-shaped manner and, in particular, are aligned with a center or central area 36 formed in a planar portion 23. In the shown example the third bumps 22 are arranged in such a way, that their longer bump axes extend along a common bump axis running in the cover longitudinal direction X.

## Claims

1. Cover (5) for a housing (1), in particular an electrical housing for accommodating electrical and/or electronic components (8),
- with a plate-shaped, rectangular cover body (14), which has a circumferential cover edge (15),
- with a circumferential flange (6) formed on the cover edge (15) for fastening the cover (1) to the housing (1),
- wherein the cover body (14) defines a cover longitudinal direction (X), a cover cross direction (Y) and a cover height direction (Z) which are perpendicular to each other, and a cover plane (E),
- wherein the cover body (14) within the flange (6) has a cover thickness (D) in the cover height direction (Z), a cover length (L) in the cover longitudinal direction (X), and a cover width (B) in the cover cross direction (Y),
- wherein the cover thickness (D) is smaller than the cover length (L) and the cover width (B),
- wherein the cover (5) has a cover bottom side (17) facing the housing (1) when the cover (15) is attached to the housing (1), and a cover upper side (18) facing away from the cover bottom side (17) in the cover height direction (Z),
- wherein the cover body (14) has at least one row of bumps (19) with an odd number of bumps (20, 21) projecting in the cover height direction (Z) from the cover plane (E),
- wherein the bumps define first bumps (20) and second bumps (21) which are different from each other and alternate in the cover longitudinal direction (X).

2. Cover (5) according to claim 1,
**characterized in that**
- the cover body (14) has planar portions (23) which adjoin the cover edge (15) and the bumps (20, 21) and which extend in the cover plane (E),
- the first bumps (20) protrude upward from the cover bottom side (17) directed away from the cover plane (E),
- the second bumps (21) project downward from the cover upper side (18) directed away from the cover plane (E).

3. Cover (5) according to claim 1 or 2,
**characterized in that**
- the bumps (20, 21) of the respective bump row (19) are of elliptical or oval design in the cover plane (E) and each have a longer bump axis (24, 25) and a shorter bump axis (26, 27) running perpendicularly to the longer bump axis (24, 25),
- all bumps (20, 21) of the respective bump row (19) are arranged in the cover body (14) such that their longer bump axes (24, 25) are parallel to each other.

4. Cover (5) according to claim 3,
**characterized in that**
- all the bumps (20, 21) of the respective bump row (19) are arranged in the cover body (14) in such a way that their longer bump axes (24, 25) run parallel to the cover cross direction (Y).

5. Cover (5) according to claim 3 or 4,
**characterized in that**
- the longer bump axes (24) of the first bumps (20) are the same size as the longer bump axes (25) of the second bumps (21),
- the shorter bump axes (26) of the first bumps (20) are larger than the shorter bump axes (27) of the second bumps (21).

6. Cover (5) according to claim 5,
**characterized in that**
- the shorter bump axes (26) of the first bumps (20) are at least twice as large as the shorter bump axes (27) of the second bumps (21).

7. Cover (6) according to any of the preceding claims,
**characterized in that**
- in the cover height direction (Z) a maximum distance (28) of the first bumps (20) from the cover plane (E) is greater than a maximum distance (29) of the second bumps (21) from the cover plane (E).

8. Cover (5) according to any of the preceding claims,
**characterized in that**
- the bumps (20, 21) of the respective bump row (19), at least in a central region, have a circular-arc-shaped contour (37, 38) cross to the cover cross direction (Y),
- a radius (30) of the contour (37) of the first bumps (20) is larger than a radius (31) of the contour (38) of the second bumps (21).

9. Cover (5) according to claim 8,
**characterized in that**
- the radius (30) of the contour (37) of the first bumps (20) is at least twice, in particular at least three times, preferably at least four times, advantageously at least five times, as large as the radius (31) of the contour (38) of the second bumps (21).

10. Cover (5) according to any of the preceding claims,
**characterized in that**
- the first bumps (20) and the second bumps (21) are directly adjacent to one another or merge into one another in the cover longitudinal direction (X).

11. Cover (5) according to any of the preceding claims,
**characterized in that**
- the cover body (14) has only one row of bumps (19), wherein the bumps (20, 21) each extend in the cover cross direction (Y) essentially over the entire cover width (B), or
- the cover body (14) has exactly two rows of bumps (19), wherein the bumps (20, 21) of the respective row of bumps (19) extend in the cover cross direction (Y) substantially over half the cover width (B) in each case, or
- the cover body (14) has n rows of bumps (19), wherein the bumps (20, 21) of the respective row of bumps (19) extend in the cross cover direction (Y) substantially over 1/n of the cover width (B) in each case.

12. Cover (5) according to any of the preceding claims,
**characterized in that**
- the bumps (20, 21) of the respective row of bumps (19) extend together in the cover longitudinal direction (X) substantially over the entire cover length (L).

13. Cover (5) according to any of the preceding claims,
**characterized in that**
- the cover body (14) with the flange (6) is a sheet metal form part made from a single piece of sheet metal by forming.

14. Cover (5) according to any of the preceding claims,
**characterized in that**
- the cover edge (15) has a circumferential collar (32) which projects in the cover height direction (Z) from the cover plane (E) and on which the flange (6) is formed,
- the flange (6) extends in a flange plane (F) which extends parallel to the cover plane (E) and which is spaced from the cover plane (E) in the cover height direction (Z).

15. Housing (1), preferably electrical housing for accommodating electrical and/or electronic components (8),
- with a housing body (2) providing a housing interior (3) and having a housing opening (4),
- with a cover (5) according to one of the preceding claims, which is fastened to the housing body (2) by the flange (6) and closes the housing opening (4).
